(19) Europäisches Patentamt / European Patent Office / Office européen des brevets

(11) **EP 3 352 186 B1**

(12) **EUROPEAN PATENT SPECIFICATION**

(45) Date of publication and mention
of the grant of the patent:
**01.04.2020   Bulletin 2020/14**

(21) Application number: **16846485.7**

(22) Date of filing: **14.09.2016**

(51) Int Cl.:
***H01G 9/20*** (2006.01)

(86) International application number:
**PCT/JP2016/077050**

(87) International publication number:
**WO 2017/047614 (23.03.2017 Gazette 2017/12)**

(54) **DYE-SENSITIZED PHOTOELECTRIC CONVERSION ELEMENT**

FARBSTOFFSENSIBILISIERTES FOTOELEKTRISCHES UMWANDLUNGSELEMENT

ÉLÉMENT DE CONVERSION PHOTOÉLECTRIQUE À COLORANT

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority:   **14.09.2015   JP 2015180265**

(43) Date of publication of application:
**25.07.2018   Bulletin 2018/30**

(73) Proprietor: **Fujikura, Ltd.**
**Tokyo 135-8512 (JP)**

(72) Inventor: **NAKA, Mami**
**Sakura-shi**
**Chiba 285-8550 (JP)**

(74) Representative: **Hoffmann Eitle**
**Patent- und Rechtsanwälte PartmbB**
**Arabellastraße 30**
**81925 München (DE)**

(56) References cited:
**EP-A2- 2 407 985        JP-A- H11 345 991
JP-A- 2004 227 843     JP-A- 2004 349 129
JP-A- 2005 251 736     JP-A- 2007 273 200
JP-A- 2013 191 401**

**Description**

TECHNICAL FIELD

The present invention relates to a dye-sensitized photoelectric conversion element.

BACKGROUND ART

A dye-sensitized photoelectric conversion element was developed by Gratzel et al. of Switzerland, and it is a next generation photoelectric conversion element which has attracted attention since it has advantages such as a high photoelectric conversion efficiency and low manufacturing cost.

A dye-sensitized photoelectric conversion element generally includes at least one dye-sensitized photoelectric conversion cell, and the dye-sensitized photoelectric conversion cell is equipped with a first electrode substrate having a transparent substrate and a transparent conductive film provided on the transparent substrate, a second electrode facing the first electrode substrate, an oxide semiconductor layer provided on the first electrode substrate or the second electrode, and a photosensitizing dye adsorbed to the oxide semiconductor layer.

In the dye-sensitized photoelectric conversion element, the photocatalytic action of the oxide semiconductor layer is caused by ultraviolet rays contained in the incident light to promote the decomposition of the photosensitizing dye and the organic substances in the electrolyte and there is thus a possibility that the power generation performance gradually decreases in the case of using, for example, $TiO_2$ or the like as the oxide semiconductor layer. Hence, for example, in the following Patent Document 1, it is disclosed that an ultraviolet absorbing layer is provided on the light incident surface on the opposite side of the second electrode of the transparent substrate. Patent Documents 2 and 3 also disclose dye-sensitized photoelectric conversion elements with UV-absorbing layers.

CITATION LIST

PATENT DOCUMENT

Patent Document 1: JP 2008-112704 A Patent Document 2: EP 2 407 985 A2

Patent Document 3: JP 2013-191401

SUMMARY OF THE INVENTION

PROBLEM TO BE SOLVED BY THE INVENTION

However, the dye-sensitized photoelectric conversion element described in Patent Document 1 above has the following problems.

Namely, in Patent Document 1 above, the ultraviolet absorbing layer is provided on the light incident surface on the opposite side of the second electrode of the transparent substrate, the quantity of ultraviolet rays incident on the dye-sensitized solar cell element thus decreases, and as a result, excellent light resistance is obtained. However, at this time, the quantity of visible light contained in the incident light also decreases so that the photoelectric conversion characteristics deteriorate in some cases. For this reason, a dye-sensitized photoelectric conversion element having excellent photoelectric conversion characteristics and light resistance has been desired.

The invention has been made in view of the above circumstances, and an object thereof is to provide a dye-sensitized photoelectric conversion element having excellent photoelectric conversion characteristics and light resistance.

MEANS FOR SOLVING PROBLEM

In order to solve the above problems, the present inventors have found out that the above problems can be solved in a case in which there is a specific relation between the transmittance of the electrolyte at a wavelength corresponding to the band gap of the oxide semiconductor constituting the oxide semiconductor layer and the transmittance of the ultraviolet absorbing layer at the same wavelength and the transmittance of the ultraviolet absorbing layer at the same wavelength is in a specific range, thereby completing the invention.

In other words, the invention is a dye-sensitized photoelectric conversion element equipped with at least one dye-sensitized photoelectric conversion cell, in which the dye-sensitized photoelectric conversion cell is equipped with a first electrode substrate having a transparent substrate and a transparent conductive film provided on the transparent substrate, a second electrode facing the first electrode substrate, an oxide semiconductor layer provided on the first electrode substrate or the second electrode, a photosensitizing dye adsorbed to the oxide semiconductor layer, and an electrolyte provided between the first electrode substrate and the second electrode, the first electrode substrate has an ultraviolet absorbing layer, and a transmittance $T_A$ (%) of the electrolyte at a wavelength corresponding to a band gap of an oxide semiconductor constituting the oxide semiconductor layer and a transmittance $T_B$ (%) of the first electrode substrate at the wavelength satisfy the following Equations (1) and (2).

$$0.01 \times T_A \times T_B < 42 \cdots (1)$$

$$3.5 \leq T_B \leq 70 \cdots (2)$$

According to the dye-sensitized photoelectric conversion element of the invention, it is possible to suppress the quantity of ultraviolet rays incident on the oxide semiconductor layer, to sufficiently suppress the photocatalytic action by the oxide semiconductor layer, and to sufficiently suppress the decomposition of the photosensitizing dye and the organic substances in the electrolyte as the product of the transmittance of the electrolyte at a wavelength corresponding to the band gap of the oxide semiconductor constituting the oxide semiconductor layer (hereinafter referred to as the "band gap wavelength") and the transmittance of the ultraviolet absorbing layer at the band gap wavelength is suppressed to be smaller than a certain value. For this reason, the dye-sensitized photoelectric conversion element of the invention can have excellent light resistance. In addition, according to the dye-sensitized photoelectric conversion element of the invention, it is sufficiently suppressed that the quantity of incident ultraviolet rays is restricted too much since the transmittance of the ultraviolet absorbing layer at the band gap wavelength is equal to or greater than a certain value. As a result, it is sufficiently suppressed that the visible light contained in the incident light is restricted too much. Consequently, the dye-sensitized photoelectric conversion element of the invention can also have excellent photoelectric conversion characteristics.

In the dye-sensitized photoelectric conversion element, it is preferable that the transmittance $T_A$ (%) of the electrolyte and the transmittance $T_B$ (%) of the first electrode substrate satisfy the following Equation (1A).

$$2.8 \leq 0.01 \times T_A \times T_B < 42 \cdots (1A)$$

According to this dye-sensitized photoelectric conversion element, it is possible to have more excellent photoelectric conversion characteristics as compared to a case in which "$0.01 \times T_A \times T_B$" is less than 2.8%.

In the dye-sensitized photoelectric conversion element, it is preferable that the electrolyte contains a triiodide ion and the transmittance $T_A$ of the electrolyte is greater than 45%.

According to this dye-sensitized photoelectric conversion element, the transmittance of the electrolyte at the band gap wavelength is sufficiently high and the concentration of triiodide ions ($I_3^-$) absorbing ultraviolet rays in the electrolyte can be sufficiently decreased. Hence, the concentration of triiodide ions carrying electrons at a low illuminance decreases and it is possible to sufficiently decrease the leakage current at a low illuminance and to have more excellent photoelectric conversion characteristics at a low illuminance.

In the dye-sensitized photoelectric conversion element, it is preferable that the transmittance $T_A$ (%) of the electrolyte and the transmittance $T_B$ (%) of the first electrode substrate satisfy the following Equations (1B) and (2A).

$$2.8 \leq 0.01 \times T_A \times T_B \leq 10 \cdots (1B)$$

$$3.5 \leq T_B \leq 20 \cdots (2A)$$

According to this dye-sensitized photoelectric conversion element, it is possible to have more excellent light resistance while having more excellent photoelectric conversion characteristics as compared to a case in which "$0.01 \times T_A \times T_B$" exceeds 10% or a case in which $T_B$ exceeds 20%.

In the dye-sensitized photoelectric conversion element, it is preferable that an average transmittance $T_C$ of the first electrode substrate at a wavelength of from 450 to 700 nm be 73% or more.

According to this dye-sensitized photoelectric conversion element, it is possible to have more excellent photoelectric conversion characteristics since it is possible to particularly increase the average transmittance of visible light.

In the dye-sensitized photoelectric conversion element, it is preferable that the average transmittance $T_C$ of the first electrode substrate be 80% or more.

According to this dye-sensitized photoelectric conversion element, it is possible to have more excellent photoelectric conversion characteristics and light resistance.

Incidentally, in the invention, the transmittance of the electrolyte refers to the transmittance measured in a case in which the optical path length is set to 50 $\mu$m.

In addition, in the invention, the "average transmittance $T_C$ of the first electrode substrate at a wavelength of from 450 to 700 nm" refers to a value represented by the following equation in the case of measuring the transmittance of the first electrode substrate at wavelengths of n locations in a range of from 450 to 700 nm.

$$\text{Average transmittance } T_C = \text{sum of transmittances at respective wavelengths measured}/n$$

EFFECT OF THE INVENTION

According to the invention, a dye-sensitized photoelectric conversion element having excellent photoelectric conversion characteristics and light resistance is provided.

BRIEF DESCRIPTION OF DRAWINGS

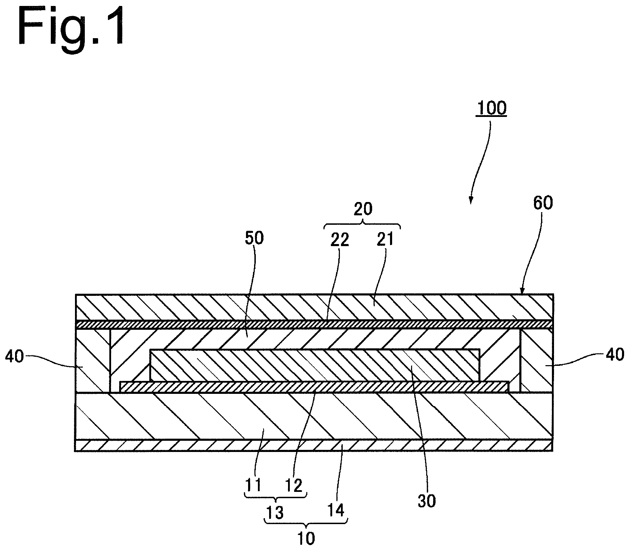

Fig. 1 is a cross-sectional diagram illustrating an embodiment of a dye-sensitized photoelectric conversion element of the invention.

MODE(S) FOR CARRYING OUT THE INVENTION

Hereinafter, embodiments of the invention will be described in detail with reference to the drawings.

Fig. 1 is a cross-sectional diagram illustrating an embodiment of a dye-sensitized photoelectric conversion element of the invention.

As illustrated in Fig. 1, a dye-sensitized photoelectric conversion element 100 is constituted by one dye-sensitized photoelectric conversion cell 60, and the dye-sensitized photoelectric conversion cell 60 is equipped with a first electrode substrate 10, a second electrode 20 facing the first electrode substrate 10, an oxide semiconductor layer 30 provided on the first electrode substrate 10, an annular sealing portion 40 connecting the first electrode substrate and the second electrode 20 to each other. An electrolyte 50 is filled in the cell space formed by the first electrode substrate 10, the second electrode 20, and the sealing portion 40. In the dye-sensitized photoelectric conversion element 100, light enters from the first electrode substrate 10 side.

The first electrode substrate 10 is constituted by a transparent conductive substrate 13 constituted by a transparent substrate 11 and a transparent conductive film 12 provided on the transparent substrate 11 and an ultraviolet absorbing layer 14 provided on the surface on the opposite side (light incident side) to the transparent conductive film 12 of the transparent substrate 11 of the transparent conductive substrate 13.

The second electrode 20 is equipped with a conductive substrate 21 and a catalyst layer 22 which is provided on the first electrode substrate 10 side of the conductive substrate 21 and contributes to the reduction of the electrolyte 50.

The oxide semiconductor layer 30 is disposed on the transparent conductive film 12 and inside the sealing portion 40. In addition, a photosensitizing dye is adsorbed to the oxide semiconductor layer 30.

Moreover, the transmittance $T_A$ (%) of the electrolyte 50 in the band gap wavelength of the oxide semiconductor constituting the oxide semiconductor layer 30 (hereinafter simply referred to as the "band gap wavelength") and the transmittance $T_B$ (%) of the first electrode substrate 10 at the band gap wavelength satisfy the following Equations (1) and (2).

$$0.01 \times T_A \times T_B < 42 \quad \cdots \quad (1)$$

$$3.5 \leq T_B \leq 70 \quad \cdots \quad (2)$$

Hereinafter, "$0.01 \times T_A \times T_B$" is referred to as "T".

According to the dye-sensitized photoelectric conversion element 100, it is possible to have excellent photoelectric conversion characteristics and light resistance.

Next, the first electrode substrate 10, the second electrode 20, the oxide semiconductor layer 30, the sealing portion 40, the electrolyte 50, and the photosensitizing dye will be described in detail.

<First Electrode Substrate>

As described above, the first electrode substrate 10 is constituted by the transparent conductive substrate 13 constituted by the transparent substrate 11 and the transparent conductive film 12 provided on the transparent substrate 11 and the ultraviolet absorbing layer 14 provided on the surface on the opposite side to the transparent conductive film 12 of the transparent substrate 11 of the transparent conductive substrate 13.

The material constituting the transparent substrate 11 may be any transparent material, for example, and examples of such a transparent material may include glass such as borosilicate glass, soda lime glass, glass which is made of soda lime and whose iron component is less than that of ordinary soda lime glass, and quartz glass, polyethylene terephthalate (PET), polyethylene naphthalate (PEN), polycarbonate (PC), and polyethersulfone (PES). The thickness of the transparent substrate 11 is appropriately determined depending on the size of the dye-sensitized photoelectric conversion element 100 and is not particularly limited, but it may be set into the range of from 50 to 40000 $\mu$m, for example.

Examples of the material constituting the transparent conductive film 12 may include a conductive metal oxide such as indium-tin-oxide (ITO), tin oxide ($SnO_2$), and fluorine-doped-tin-oxide (FTO). The transparent conductive film 12 may be constituted by a single layer or a laminate consisting of a plurality of layers which are constituted by different conductive metal oxides. It is preferable that the transparent conductive film 12 be constituted by FTO since FTO exhibits high heat resistance and chemical resistance in a case in which the transparent conductive film 12 is constituted by a single layer. The thickness of the transparent conductive film 12 may be set into the range of from 0.01 to 2 $\mu$m, for example.

The ultraviolet absorbing layer 14 may be a layer capable of absorbing ultraviolet rays, and as the ultraviolet absorbing layer 14, for example, an ultraviolet absorbing resin composition containing an ultraviolet absorber and a resin and the like can be used.

The thickness of the ultraviolet absorbing layer 14 cannot be said unconditionally since it varies depending on the kind and concentration of the ultraviolet absorber in the ultraviolet absorbing layer 14, but it is typically about from 5 to 500 $\mu$m.

(Second electrode)

As described above, the second electrode 20 is equipped with the conductive substrate 21 and the conductive catalyst layer 22 which is provided on the side of the conductive substrate 21 facing the first electrode 10 and which contributes to the reduction of the electrolyte 50.

The conductive substrate 21 is constituted by, for example, a corrosion-resistant metallic material such as titanium, nickel, platinum, molybdenum, tungsten, aluminum and stainless steel or a substrate obtained by forming a film composed of a conductive oxide such as ITO or FTO on the transparent substrate 11 described above. The thickness of the conductive substrate 21 is appropriately determined depending on the size of the dye-sensitized photoelectric conversion element 100 and is not particularly limited, but the thickness may be set to from 0.005 to 4 mm, for example.

The catalyst layer 22 is constituted by platinum, a carbon-based material, a conductive polymer or the like. Here, as the carbon-based material, carbon nanotubes are particularly suitably used.

<Oxide semiconductor layer>

The oxide semiconductor layer 13 is constituted by oxide semiconductor particles. The oxide semiconductor particles are constituted by, for example, titanium oxide ($TiO_2$), zinc oxide (ZnO), tungsten oxide ($WO_3$), niobium oxide ($Nb_2O_5$), strontium titanate ($SrTiO_3$), tin oxide ($SnO_2$), indium oxide ($In_3O_3$), zirconium oxide ($ZrO_2$), thallium oxide ($Ta_2O_5$), lanthanum oxide ($La_2O_3$), yttrium oxide ($Y_2O_3$), holmium oxide ($Ho_2O_3$), bismuth oxide ($Bi_2O_3$), cerium oxide ($CeO_2$), aluminum oxide ($Al_2O_3$), or two or more kinds of these. The thickness of the oxide semiconductor layer 30 may be set to from 0.1 to 100 $\mu$m, for example.

<Sealing portion>

Examples of the sealing portion 40 include a resin such as a thermoplastic resin containing a modified polyolefin resin, a vinyl alcohol polymer or the like, and an ultraviolet curable resin. Examples of the modified polyolefin resin include an ionomer, an ethylene-vinyl acetate anhydride copolymer, an ethylene-methacrylic acid copolymer and an ethylene-vinyl alcohol copolymer. These resins can be used alone or in combination of two or more types.

(Electrolyte)

The electrolyte 50 contains a redox couple such as, for example, $I^-/I_3^-$ and an organic solvent. It is possible to use acetonitrile, methoxy acetonitrile, methoxy propionitrile, propionitrile, ethylene carbonate, propylene carbonate, diethyl carbonate, γ-butyrolactone, valeronitrile as the organic solvent. Examples of the redox couple include a redox couple such as bromine/bromide ion, a zinc complex, an iron complex, and a cobalt complex in addition to $I^-/I_3^-$, for example. In addition, the electrolyte 50 may use an ionic liquid instead of the organic solvent. As the ionic liquid, it is possible to use, for example, an ordinary temperature molten salt which is a known iodine salt, such as a pyridinium salt, an imidazolium salt, and a triazolium salt, and which is in a molten state at around room temperature. As such an ordinary temperature molten salt, it is possible to suitably use, for example, 1-hexyl-3-methylimidazolium iodide, 1-ethyl-3-propylimidazolium iodide, 1-ethyl-3-methylimidazolium iodide, 1,2-dimethyl-3-propylimidazolium iodide, 1-butyl-3-methylimidazolium iodide or 1-methyl-3-propylimidazolium iodide.

In addition, the electrolyte 50 may use a mixture of the ionic liquid above and the organic solvent above instead of the organic solvent above.

In addition, it is possible to add an additive to the electrolyte 50. Examples of the additive include benzimidazole such as 1-methylbenzimidazole (NMB) or 1-butylbenzimidazole (NBB), LiI, tetrabutylammonium iodide, 4-t-butylpyridine and guanidium thiocyanate. Among them, benzimidazole is preferable as the additive.

Moreover, as the electrolyte 50, a nanocomposite gel electrolyte which is a quasi-solid electrolyte obtained by kneading nanoparticles such as $SiO_2$, $TiO_2$, and carbon nanotubes with the electrolyte above to form a gel-like form may be used, or an electrolyte gelled using an organic gelling agent such as polyvinylidene fluoride, a polyethylene oxide derivative, and an amino acid derivative may also be used.

(Photosensitizing dye)

Examples of the photosensitizing dye include a ruthenium complex having a ligand containing a bipyridine structure or a terpyridine structure, and an organic dye such as porphyrin, eosin, rhodamine, or merocyanine.

Incidentally, in a case in which the dye-sensitized photoelectric conversion element 100 is used indoors or in an environment with a low illuminance (10 to 10000 lux), it is preferable to use a ruthenium complex having a ligand containing a bipyridine structure as the photosensitizing dye.

<Transmittance>

In the dye-sensitized photoelectric conversion element 100, the transmittance $T_A$ (%) of the electrolyte 50 at the band gap wavelength and the transmittance $T_B$ (%) of the first electrode substrate 10 at the band gap wavelength may satisfy Equations (1) and (2) above at the same time.

(T)

When T is 42% or more, the photocatalytic action of the oxide semiconductor layer 30 is caused by ultraviolet rays contained in the incident light to promote the decomposition of the photosensitizing dye and the organic substances in the electrolyte 50, and it is impossible to have excellent light resistance.

T is preferably 30% or less, more preferably 19% or less, still more preferably 15% or less, yet still more preferably 12% or less, and particularly preferably 10% or less.

However, T is preferably 1.4% or more in order to improve the efficiency of light utilization as much as possible and thus to maintain the photoelectric conversion efficiency. In particular, T is preferably 2.8% or more. In this case, it is possible to have more excellent photoelectric conversion characteristics as compared to a case in which T is less than 2.8%.

In addition, it is preferable that T satisfy the following Equation (1B) in a case in which the transmittance $T_B$ (%) of the first electrode substrate 10 satisfies the following Equation (2A).

$$2.8 \leq T \leq 10 \quad \cdots \quad (1B)$$

$$3.5 \leq T_B \leq 20 \quad \cdots \quad (2A)$$

In this case, it is possible to have more excellent light resistance while having more excellent photoelectric conversion characteristics as compared to a case in which T exceeds 10% or a case in which $T_B$ exceeds 20%.

(T$_A$)

The transmittance T$_A$ of the electrolyte 50 is not particularly limited as long as T$_A$ and T$_B$ satisfy Equations (1) and (2) above, but it is preferable that the transmittance T$_A$ of the electrolyte 50 is greater than 45% in a case in which the electrolyte 50 contains a triiodide ion.

In this case, the transmittance of the electrolyte 50 at the band gap wavelength becomes sufficiently high, and the concentration of triiodide ions absorbing ultraviolet rays in the electrolyte 50 can be sufficiently decreased. Hence, the concentration of triiodide ions carrying electrons at a low illuminance decreases and it is possible to sufficiently decrease the leakage current at a low illuminance and to have more excellent photoelectric conversion characteristics at a low illuminance.

T$_A$ is preferably 50% or more and more preferably 70% or more.

However, it is preferable that T$_A$ be 99.5% or less since the power is not generated unless a redox couple is contained in the electrolyte 50 even in a small amount.

(T$_B$)

The transmittance T$_B$ of the first electrode substrate 10 is not particularly limited as long as T$_A$ and T$_B$ satisfy Equations (1) and (2) above, but it is preferable that T$_B$ (%) be 20% or less. In this case, it is possible to have more excellent light resistance as compared to a case in which T$_B$ (%) exceeds 20%.

It is more preferable that T$_B$ (%) be 10% or less.

(T$_C$)

It is preferable that the average transmittance T$_C$ of the first electrode substrate 10 at a wavelength of from 450 to 700 nm be 73% or more.

In this case, it is possible to particularly increase the average transmittance of visible light, and thus the dye-sensitized photoelectric conversion element 100 can have more excellent photoelectric conversion characteristics.

The average transmittance T$_C$ of the first electrode substrate 10 is preferably 75% or more. In particular, it is more preferable that the average transmittance T$_C$ of the first electrode substrate 10 be 80% or more. In this case, it is possible to have more excellent photoelectric conversion characteristics and light resistance.

The average transmittance T$_C$ of the first electrode substrate 10 may be 100% or less.

Next, the method of manufacturing the dye-sensitized solar cell element 100 will be described.

First, a transparent conductive substrate 13 obtained by forming a transparent conductive film 12 on one transparent substrate 11 is prepared.

As the method of forming the transparent conductive film 12, a sputtering method, a vapor deposition method, a spray pyrolysis deposition method, a CVD method or the like is used.

Next, the oxide semiconductor layer 30 is formed on the transparent conductive film 12. The oxide semiconductor layer 30 is formed by printing a paste for oxide semiconductor layer formation containing oxide semiconductor particles and then firing it.

The paste for oxide semiconductor layer formation contains a resin such as polyethylene glycol and a solvent such as terpineol in addition to the oxide semiconductor particles.

It is possible to use, for example, a screen printing method, a doctor blading method, or a bar coating method as the printing method of the paste for oxide semiconductor layer formation.

The firing temperature varies depending on the kind of the oxide semiconductor particles but is typically from 350 to 600°C, and the firing time also varies depending on the kind of the oxide semiconductor particles but is typically from 1 to 5 hours.

In this manner, the working electrode 10 is obtained.

Next, the photosensitizing dye is adsorbed on the surface of the oxide semiconductor layer 30 of the working electrode. For this, the photosensitizing dye may be adsorbed on the oxide semiconductor layer 30 by immersing the working electrode in a solution containing the photosensitizing dye, making the photosensitizing dye adsorb on the oxide semiconductor layer 30 and then washing out the extra photosensitizing dye with the solvent component of the above solution, and performing drying. However, the photosensitizing dye may be adsorbed on the oxide semiconductor layer 30 by coating a solution containing the photosensitizing dye on the oxide semiconductor layer 30 and then drying.

Next, the electrolyte 50 is prepared. The electrolyte 50 may be constituted by a paste containing a redox couple.

Subsequently, the electrolyte 50 is disposed on the oxide semiconductor layer 30. For example, the electrolyte 50 can be disposed by a printing method such as screen printing or the like.

Next, an annular sealing portion forming body is prepared. The sealing portion forming body can be obtained, for example, by preparing a resin film for sealing and forming one quadrangular opening in the resin film for sealing.

Thereafter, this sealing portion forming body is bonded onto the transparent conductive substrate 13. At this time, bonding of the sealing portion forming body to the transparent conductive substrate 13 can be conducted, for example, by melting and heating the sealing portion forming body.

Next, the second electrode 20 is prepared, disposed so as to close the opening of the sealing portion forming body, and then bonded to the sealing portion forming body. At this time, the sealing portion forming body may be bonded to the second electrode 20 in advance and this sealing portion forming body may be bonded to the sealing portion forming body on the first electrode substrate 10 side. Bonding of the sealing portion forming body to the second electrode 20 may be conducted under the atmospheric pressure or reduced pressure, but it is preferably conducted under reduced pressure.

Finally, the ultraviolet absorbing layer 14 is provided on the surface on the opposite side (light incident side) to the transparent conductive film 12 of the transparent substrate 11 of the transparent conductive substrate 13.

Incidentally, the electrolyte 50 and the first electrode substrate 10 are selected so that T and the transmittance $T_B$ satisfy the following Equations (1) and (2).

$$T < 42 \cdots (1)$$

$$3.5 \leq T_B \leq 70 \cdots (2)$$

Specifically, the transmittance $T_A$ of the electrolyte 50 may be great in a case in which $T_B$ is small since the ultraviolet rays are sufficiently absorbed by the first electrode substrate 10. In this case, for example, the concentration of triiodide ions in the electrolyte 50 may be decreased. Specifically, in a case in which $T_B$ is 3.5% or more and less than 42%, the transmittance $T_A$ of the electrolyte 50 may be 100% since T < 42% is already satisfied by only $T_B$.

On the other hand, in a case in which $T_B$ is great, the transmittance $T_A$ of the electrolyte 50 is required to be decreased since the quantity of ultraviolet rays absorbed by the first electrode substrate 10 decreases. In this case, the concentration of triiodide ions in the electrolyte 50 may be increased. Specifically, in a case in which $T_B$ is 42% or more and 70% or less, the transmittance $T_A$ of the electrolyte 50 may be set to be in a range of greater than 45% and less than 100%, and in this case, for example, the concentration of triiodide ions in the electrolyte 50 may be set to from 0 to 0.05 M.

The dye-sensitized solar cell element 100 is obtained in the manner described above.

The invention is not limited to the embodiments described above. For example, in the embodiments described above, the dye-sensitized photoelectric conversion element 100 has a structure in which the porous oxide semiconductor layer 30 is provided on the transparent conductive film 12 of the first electrode substrate 10 and light is thus received from the first electrode substrate 10 side, but the dye-sensitized photoelectric conversion element may have a structure in which an opaque material (for example, metal substrate) is used as the base material on which the porous oxide semiconductor layer 30 is formed, a transparent conductive substrate is used as a base material forming the second electrode 20, and light is thus received from the second electrode 20 side, and further, it may have a structure in which light is received from both surfaces.

In addition, in the embodiments described above, the dye-sensitized photoelectric conversion element 100 is constituted by one dye-sensitized photoelectric conversion cell 60, but the dye-sensitized photoelectric conversion element may be equipped with a plurality of dye-sensitized photoelectric conversion cells 60. Here, the plurality of dye-sensitized photoelectric conversion cells 60 may be connected in series or may be connected in parallel.

In addition, in the above embodiment, the dye-sensitized photoelectric conversion element may further have a back sheet which covers the dye-sensitized photoelectric conversion cell 60 from the second electrode 20 side.

In addition, in the above embodiment, the ultraviolet absorbing layer 14 is provided on the transparent substrate 11, but the ultraviolet absorbing layer 14 may not be provided on the transparent substrate 11 and the transparent substrate 11 may also serve as the ultraviolet absorbing layer 14. In this case, the transparent substrate 11 may be constituted by an ultraviolet absorbing glass composition containing an ultraviolet absorber. In addition, in this case, the thickness of the transparent substrate 11 cannot be said unconditionally since it varies depending on the kind and concentration of the ultraviolet absorber contained in the transparent substrate 11 but it is typically about from 0.05 to 5 mm.

Example 1

Hereinafter, the contents of the invention will be described more specifically with reference to Examples, but the invention is not limited to the following Examples.

(Examples 1 to 9 and Comparative Examples 1 to 3)

<Preparation of Electrolyte for Dye-Sensitized Photoelectric Conversion Element>

(1) Electrolyte

Electrolytes 1 to 4 having the following compositions were prepared.

Electrolyte 1

iodine (I$_2$) 0.002 M
1,2-dimethyl-3-propylimidazolium iodide (DMPImI) 0.6 M
n-butylbenzimidazole (NBB) 0.1 M
solvent composed of 3-methoxypropionitrile (MPN)

Electrolyte 2

1-hexyl-3-methylimidazolium iodide (HMImI) 0.6 M
n-methylbenzimidazole (NMB) 0.3 M
guanidine thiocyanate (GuSCN) 0.1 M
solvent composed of 3-methoxypropionitrile (MPN)

Electrolyte 3

iodine (I$_2$) 0.005 M
1,2-dimethyl-3-propylimidazolium iodide (DMPImI) 0.6 M
n-butylbenzimidazole (NBB) 0.1 M
solvent composed of 3-methoxypropionitrile (MPN)

Electrolyte 4

iodine (I$_2$) 0.01 M
1,2-dimethyl-3-propylimidazolium iodide (DMPImI) 0.6 M
n-butylbenzimidazole (NBB) 0.1 M
solvent composed of 3-methoxypropionitrile (MPN)

(2) Transmittance

The transmittance $T_A$ of the electrolytes 1 to 4 at a wavelength of 387.5 nm (wavelength corresponding to the band gap of TiO$_2$) is as presented in Table 1.
The transmittance $T_A$ of the electrolytes 1 to 4 at a wavelength of 387.5 nm was measured in the following manner.
First, two pieces of soda lime glass having dimensions of 45 mm × 12 mm × 2.2 mm were prepared, a pinhole having a diameter of 0.5 mm was formed on one soda lime glass. Thereafter, two pieces of soda lime glass were allowed to face each other in a state of sandwiching an annular sealing portion forming body composed of "Bynel" (trade name, manufactured by DuPont) therebetween and stuck together by heating and melting the sealing portion forming body. An empty cell for transmittance measurement was thus fabricated. At this time, the distance between the two pieces of soda lime glass was 50 μm. Thereafter, the empty cell was irradiated with light from the following light source, and the transmitted light was received and the transmission spectrum was measured by using the following spectrometer. The transmission spectrum of this empty cell was taken as the background.

Light source: Deuterium and halogen light source ("DH-2000-BAL" product name, manufactured by Ocean Optics)
Spectrometer: Fiber multichannel spectrometer ("USB4000-XR1-ES" product name, manufactured by Ocean Optics)

Next, the electrolytes 1 to 4 were injected into the empty cells through the pinholes thereof, and the pinholes were sealed with a sealing resin composed of "Himilan" (trade name, manufactured by Du Pont-Mitsui Polychemicals), thereby obtaining measurement cells for transmittance measurement.

Thereafter, for this transmittance measurement cell, the transmission spectrum was measured in the same manner as in the case of the empty cell and the transmittance $T_A$ (%) of the electrolyte at a wavelength of 387.5 nm was measured. The results are presented in Table 1. The optical path length of the electrolyte when measuring the transmission spectrum of the electrolyte was 50 $\mu$m.

<Preparation of First Electrode Substrate for Transmittance Measurement>

(1) First Electrode Substrate for Transmittance Measurement

The first electrode substrate for transmittance measurement was prepared in the following manner.

In other words, first, an FTO/glass substrate ("TEC-A7" trade name, manufactured by Pilkington Group Limited) having an FTO film formed on a glass substrate was prepared. Next, one sheet or two to five sheets of the following three kinds of ultraviolet absorbing layers 1 to 3 were superimposed on and bonded to the FTO/glass substrate, thereby obtaining the first electrode substrate for transmittance measurement.

Ultraviolet absorbing layer 1

UV cut coat resin ("UV cut coat" trade name, manufactured by JAPAN NANO COAT CO., LTD, thickness: 15 $\mu$m)

Ultraviolet absorbing layer 2

UV cut film ("ARCTOP" trade name, manufactured by Asahi Glass Co., Ltd, thickness: 130 $\mu$m)

Ultraviolet absorbing layer 3

UV cut coat film ("Lag Protect G-030EV50" trade name, manufactured by LINTEC Corporation, thickness: 50 $\mu$m)

(2) Transmittance

The transmittance $T_B$ of the first electrode substrate for transmittance measurement at a wavelength of 387.5 nm is as presented in Table 1.

The transmittance $T_B$ of the first electrode substrate for transmittance measurement at a wavelength of 387.5 nm was measured in the following manner.

In other words, the first electrode substrate for transmittance measurement was irradiated with light from the light source used for the measurement of the transmittance of the electrolyte, the transmitted light was received and the transmission spectrum was measured by using the spectrometer used for the measurement of the transmittance of the electrolyte in the same manner, and the transmittance $T_B$ (%) of the first electrode substrate for transmittance measurement at a wavelength of 387.5 nm was measured. The results are presented in Table 1.

<Fabrication of Dye-Sensitized Photoelectric Conversion Element>

First, an FTO/glass substrate ("TEC-A7" trade name, manufactured by Pilkington Group Limited) having an FTO film formed on a glass substrate was prepared. Thereafter, laser scribing was performed at predetermined positions of this FTO/glass substrate to form four FTO portions separated from each other on the glass substrate. Next, this substrate was subjected to cleaning and UV-O$_3$ treatment, and a first titanium oxide paste containing titanium oxide was coated on each of the four FTO portions of the substrate three times by screen printing and dried to obtain a first dried body, and a second titanium oxide paste containing titanium oxide was then coated on the first dried body by screen printing to form a precursor of the oxide semiconductor layer. At this time, "PST-21NR" (trade name, manufactured by JGC C&C) was used as the first titanium oxide paste and "PST-400C" (trade name, manufactured by JGC C&C) was used as the second titanium oxide paste. Meanwhile, a silver paste and a paste containing glass frit were coated on each of the four FTO portions. An unfired substrate was thus obtained. Finally, this unfired substrate was placed in an oven and fired at 500°C for 1 hour, thereby obtaining a porous titanium oxide layer having dimensions of 17 mm $\times$ 42

mm $\times$ 12 $\mu$m on each of the four FTO portions. In addition, a metal layer constituted by silver and a glass layer constituted by glass were also obtained on each of the four FTO portions. A structure having four working electrodes on a common glass substrate was obtained.

Next, a dye solution was fabricated by dissolving Dye Z907 of a photosensitizing dye in a mixed solvent in which acetonitrile and t-butyl alcohol were mixed at a ratio of 1: 1 (volume ratio) so as to have a concentration of 0.2 mM. Thereafter, the structure was immersed in this dye solution at room temperature for 24 hours to make the photosensitizing dye adsorb to the porous titanium oxide layer.

Meanwhile, four pieces of Ti foils having dimensions of 46 mm $\times$ 20 mm $\times$ 40 $\mu$m were prepared, and Pt was deposited on each Ti foil by a sputtering method. A second electrode was thus obtained.

Next, an annular thermoplastic resin sheet composed of "Bynel" (trade name, manufactured by DuPont) was disposed on each working electrode. At this time, the porous titanium oxide layer was disposed inside the annular thermoplastic resin sheet. Thereafter, the thermoplastic resin sheet was heated at 180°C for 5 minutes to be melted and bonded to the working electrode.

Meanwhile, the electrolyte presented in Table 1 was coated so as to cover the porous titanium oxide layer by a screen printing method. At this time, the amount of electrolyte used was 20 $\mu$L per cell.

Thereafter, the second electrode was superimposed on the working electrode so as to sandwich the electrolyte between the working electrode and the second electrode, and the sealing portion was heated and melted under reduced pressure (1000 Pa) to bond the second electrode and the sealing portion to each other. Four cells were thus obtained on a common glass substrate.

Subsequently, the four cells were connected in series with a silver paste composed of "DOTITE" (product name, manufactured by FUJIKURA KASEI CO., LTD.), and the four cells were finally fixed to the glass substrate so as to be covered with an aluminum back sheet by using butyl rubber.

Finally, the ultraviolet absorbing layer presented in Table 1 was attached to the surface to be the light incident surface (the surface on the opposite side to the FTO film) of the glass substrate. The first electrode substrate composed of a FTO/glass substrate and an ultraviolet absorbing layer was thus constituted.

A dye-sensitized photoelectric conversion element was thus obtained.

<Evaluation of Characteristics>

(Photoelectric Conversion Characteristics)

For the dye-sensitized photoelectric conversion elements of Examples 1 to 9 and Comparative Examples 1 to 3 obtained as described above, the IV curves were measured in a state in which the entire cell was uniformly irradiated with white light of 200 lux and the maximum output operating power $Pm_0$ ($\mu$W) was calculated. The results are presented in Table 1. Incidentally, the light source, illuminometer, and power supply used for the measurement of the IV curve are as follows.

Light source: White LED ("LEL-SL 5N-F" product name, manufactured by TOSHIBA LIGHTING & TECHNOLOGY CORPORATION)
Illuminometer: "AS ONE LM-331" product name, manufactured by AS ONE Corporation
Power supply: Voltage/current generator ("ADVANTEST R6246" product name, manufactured by Advantest Corporation)

In addition, the acceptance criteria of the photoelectric conversion characteristics were as follows.

(Acceptance Criteria)

$Pm_0$ is 190 $\mu$W or more

(Light Resistance)

The dye-sensitized photoelectric conversion elements of Examples 1 to 9 and Comparative Examples 1 to 3 obtained as described above were irradiated with pseudo-sunlight from a metal halide lamp for 200 hours. The temperature of the dye-sensitized photoelectric conversion cell during the pseudo-sunlight irradiation was fixed at 20°C. Thereafter, the IV curves before and after the pseudo-sunlight irradiation were measured by the apparatus used for the evaluation of photoelectric conversion characteristics, and the rate of power decline $Pm/Pm_0$ was calculated. The results are presented in Table 1. Incidentally, Pm denotes the power measured after the dye-sensitized photoelectric conversion element was irradiated with pseudo-sunlight from a metal halide lamp for 200 hours. In addition, the acceptance criteria for light resistance were as follows.

(Acceptance Criteria)

The rate of power decline $Pm/Pm_0$ is 0.90 or more

[Table 1]

| | Electrolyte | Ultraviolet absorbing layer | Number of Ultraviolet absorbing layers (sheets) | $T_A$ (%) | $T_B$ (%) | T (%) | $T_C$ (%) | Photoelectric conversion characteristics $Pm_0$ (μW) | Light resistance $Pm/Pm_0$ |
|---|---|---|---|---|---|---|---|---|---|
| Example 1 | Electrolyte 1 | Ultraviolet absorbing layer 1 | 1 | 75.0 | 41.0 | 30.8 | 81.8 | 206.0 | 0.95 |
| Example 2 | Electrolyte 2 | Ultraviolet absorbing layer 1 | 1 | 99.5 | 41.0 | 40.8 | 82.0 | 194.2 | 0.93 |
| Example 3 | Electrolyte 3 | Ultraviolet absorbing layer 1 | 1 | 48.7 | 41.0 | 20.0 | 81.5 | 193.6 | 0.95 |
| Example 4 | Electrolyte 1 | Ultraviolet absorbing layer 1 | 2 | 75.0 | 22.6 | 17.0 | 81.5 | 205.1 | 0.95 |
| Example 5 | Electrolyte 1 | Ultraviolet absorbing layer 1 | 3 | 75.0 | 12.5 | 9.3 | 81.2 | 204.6 | 0.96 |
| Example 6 | Electrolyte 1 | Ultraviolet absorbing layer 1 | 4 | 75.0 | 6.9 | 5.2 | 81.0 | 204.1 | 0.96 |
| Example 7 | Electrolyte 1 | Ultraviolet absorbing layer 1 | 5 | 75.0 | 3.8 | 2.8 | 80.8 | 203.4 | 0.98 |
| Example 8 | Electrolyte 1 | Ultraviolet absorbing layer 3 | 1 | 75.0 | 47.0 | 35.3 | 79.7 | 191.7 | 0.92 |
| Example 9 | Electrolyte 4 | Ultraviolet absorbing layer 1 | 1 | 23.7 | 41.0 | 9.7 | 81.7 | 205.7 | 0.94 |
| Comparative Example 1 | Electrolyte 1 | Ultraviolet absorbing layer 2 | 1 | 75.0 | 2.5 | 1.8 | 81.8 | 185.4 | 0.97 |
| Comparative Example 2 | Electrolyte 1 | Nil | 0 | 75.0 | 74.5 | 55.9 | 82.0 | 206.3 | 0.0 |
| Comparative Example 3 | Electrolyte 2 | Nil | 0 | 99.5 | 74.5 | 74.1 | 82.2 | 207.0 | 0.0 |

From the results presented in Table 1, it has been found that the dye-sensitized photoelectric conversion elements of Examples 1 to 9 satisfy the acceptance criteria for both photoelectric conversion characteristics and light resistance. In contrast, it has been found that the dye-sensitized photoelectric conversion elements of Comparative Examples 1 to 3 do not satisfy the acceptance criteria for at least either of photoelectric conversion characteristics or light resistance.

From the above, it has been confirmed that excellent photoelectric conversion characteristics and light resistance are exhibited according to the electrolyte for dye-sensitized photoelectric conversion element of the invention.

EXPLANATIONS OF LETTERS OR NUMERALS

10 ··· First electrode substrate
11 ··· Transparent substrate
12 ··· Transparent conductive film
13 ··· Transparent conductive substrate
14 ··· Ultraviolet absorbing layer
20 ··· Second electrode
30 ··· Oxide semiconductor layer
50 ··· Electrolyte
60 ··· Dye-sensitized photoelectric conversion cell
100 ··· Dye-sensitized photoelectric conversion element

## Claims

1. A dye-sensitized photoelectric conversion element (100) comprising at least one dye-sensitized photoelectric conversion cell (60) which includes

   - a first electrode substrate (10) having a transparent substrate (11) and, provided thereon, a transparent conductive film (12), and further having an ultraviolet absorbing layer (14),
   - a second electrode (20) facing the first electrode substrate (10),
   - an oxide semiconductor layer (30) provided on the first electrode substrate (10) or the second electrode (20),
   - a photosensitizing dye adsorbed to the oxide semiconductor layer (30), and
   - an electrolyte (50) provided between the first electrode substrate (10) and the second electrode (20),

   **characterized in that** the transmittance $T_A$ (%) of the electrolyte (50) at a wavelength corresponding to a band gap of an oxide semiconductor constituting the oxide semiconductor layer and the transmittance $T_B$ (%) of the first electrode substrate at that wavelength satisfy the Equations:

   $$(0.01 \times T_A \times T_B) < 42 \qquad (1)$$

   $$3.5 \leq T_B \leq 70 \qquad (2).$$

2. The dye-sensitized photoelectric conversion element (100) of claim 1, wherein $T_A$ (%) and $T_B$ (%) satisfy the Equation

   $$2.8 \leq (0.01 \times T_A \times T_B) < 42 \qquad (1A).$$

3. The dye-sensitized photoelectric conversion element (100) of claim 1 or 2, wherein the electrolyte (50) contains a triiodide ion, and $T_A$ is > 45%, and preferably $\geq$ 50%.

4. The dye-sensitized photoelectric conversion element (100) of claim 3, wherein $T_A$ is $\geq$ 50%.

5. The dye-sensitized photoelectric conversion element (100) of any of claims 1-4, wherein $T_A$ (%) and $T_B$ (%) satisfy the Equations

$$2.8 \leq 0.01 \times T_A \times T_B \leq 10 \quad (1B)$$

$$3.5 \leq T_B \leq 20 \quad\quad (2A).$$

6. The dye-sensized photoelectric conversion element (100) of any of claims 1-5, wherein an average transmittance $T_C$ of the first electrode substrate (10) at a wavelength of 450-700 nm is $\geq 73\%$.

7. The dye-sensitized photoelectric conversion element (100) of claim 6, wherein $T_C$ is $\geq 80\%$.

**Patentansprüche**

1. Farbstoffsensibilisiertes fotoelektrisches Umwandlungselement (100), umfassend mindestens eine farbstoffsensibilisierte fotoelektrische Umwandlungszelle (60), umfassend

 - ein erstes Elektrodensubstrat (10), die ein transparentes Substrat (11) und, darauf bereitgestellt, eine transparente leitfähige Folie (12) aufweist, und die ferner eine ultraviolette Absorptionsschicht (14) aufweist,
 - eine zweite Elektrode (20), die dem ersten Elektrodensubstrat (10) gegenüberliegt,
 - eine Oxidhalbleiterschicht (30), die auf dem ersten Elektrodensubstrat (10) oder der zweiten Elektrode (20) bereitgestellt ist,
 - einen fotosensibilisierenden Farbstoff, der auf der Oxidhalbleiterschicht (30) adsorbiert ist und
 - einen Elektrolyten (50), der zwischen dem ersten Elektrodensubstrat (10) und der zweiten Elektrode (20) bereitgestellt ist,

 **dadurch gekennzeichnet, dass** die Transmission $T_A$ (%) des Elektrolyten (50) bei einer Wellenlänge, die einer Bandlücke eines Oxidhalbleiters, der die Oxidhalbleiterschicht bildet, entspricht und die Transmission $T_B$ (%) des ersten Elektrodensubstrats bei dieser Wellenlänge die Gleichungen:

$$(0,01 \times T_A \times T_B) < 42 \quad\quad (1)$$

$$3,5 \leq T_B \leq 70 \quad\quad (2)$$

 erfüllen.

2. Farbstoffsensibilisiertes fotoelektrisches Umwandlungselement (100) gemäß Anspruch 1, worin $T_A$ (%) und $T_B$ (%) die Gleichung

$$2,8 \leq (0,01 \times T_A \times T_B) < 42 \quad (1A)$$

 erfüllen.

3. Farbstoffsensibilisiertes fotoelektrisches Umwandlungselement (100) gemäß Anspruch 1 oder 2, worin der Elektrolyt (50) ein Triiodidion enthält und $T_A > 45\%$ und vorzugsweise $\geq 50\%$ ist.

4. Farbstoffsensibilisiertes fotoelektrisches Umwandlungselement (100) gemäß Anspruch 3, worin $T_A \geq 50\%$ ist.

5. Farbstoffsensibilisiertes fotoelektrisches Umwandlungselement (100) gemäß mindestens einem der Ansprüche 1-4, worin $T_A$ (%) und $T_B$ (%) die Gleichungen

$$2,8 \leq 0,01 \times T_A \times T_B \leq 10 \quad (1B)$$

$$3,5 \leq T_B \leq 20 \qquad (2A)$$

erfüllen.

6. Farbstoffsensibilisiertes fotoelektrisches Umwandlungselement (100) gemäß mindestens einem der Ansprüche 1-5, worin eine durchschnittliche Transmission $T_C$ des ersten Elektrodensubstrats (10) bei einer Wellenlänge von 450-700 nm $\geq$ 73% ist.

7. Farbstoffsensibilisiertes fotoelektrisches Umwandlungselement (100) gemäß Anspruch 6, worin $T_C \geq$ 80% ist.

**Revendications**

1. Élément de conversion photoélectrique à colorant (100) comprenant au moins une cellule de conversion photoélectrique à colorant (60) qui inclut

   - un substrat de première électrode (10) ayant un substrat transparent (11) et, disposé sur celui-ci, un film conducteur transparent (12) et ayant en outre une couche d'absorption des ultraviolets (14),
   - une seconde électrode (20) faisant face au substrat de première électrode (10),
   - une couche de semi-conducteur à oxyde (30) disposée sur le substrat de première électrode (10) ou la seconde électrode (20),
   - un colorant photosensibilisant adsorbé sur la couche de semi-conducteur à oxyde (30), et
   - un électrolyte (50) disposé entre le substrat de première électrode (10) et la seconde électrode (20),

   **caractérisé en ce que** la transmittance $T_A$ (%) de l'électrolyte (50) à une longueur d'onde correspondant à une bande interdite d'un semi-conducteur à oxyde constituant la couche de semi-conducteur à oxyde et la transmittance $T_B$ (%) du substrat de première électrode à cette longueur d'onde satisfont aux équations :

   $$(0,01 \times T_A \times T_B) < 42 \qquad (1)$$

   $$3,5 \leq T_B \leq 70 \qquad (2).$$

2. Élément de conversion photoélectrique à colorant (100) selon la revendication 1, dans lequel $T_A$ (%) et $T_B$ (%) satisfont à l'équation :

   $$2,8 \leq (0,01 \times T_A \times T_B) < 42 \qquad (1A).$$

3. Élément de conversion photoélectrique à colorant (100) selon la revendication 1 ou 2, dans lequel l'électrolyte (50) contient un ion triiodure et $T_A$ est > 45 %, et de préférence $\geq$ 50 %.

4. Élément de conversion photoélectrique à colorant (100) selon la revendication 3, dans lequel $T_A$ est $\geq$ 50 %.

5. Élément de conversion photoélectrique à colorant (100) selon l'une quelconque des revendications 1 à 4, dans lequel $T_A$ (%) et $T_B$ (%) satisfont aux équations

   $$2,8 \leq 0,01 \times T_A \times T_B \leq 10 \qquad (1B)$$

   $$3,5 \leq T_B \leq 20 \qquad (2A).$$

6. Élément de conversion photoélectrique à colorant (100) selon l'une quelconque des revendications 1 à 5, dans lequel une transmittance moyenne $T_C$ du substrat de première électrode (10) à une longueur d'onde comprise entre 450 et 700 nm est $\geq$ 73 %.

7. Élément de conversion photoélectrique à colorant (100) selon la revendication 6, dans lequel $T_C$ est $\geq$ 80 %.

# Fig.1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2008112704 A
- EP 2407985 A2
- JP 2013191401 A